# EUROPEAN PATENT APPLICATION

(11) **EP 1 906 720 A1**
(43) Date of publication of application: **02.04.2008**
(21) Application number: 06797819.7
(22) Date of filing: 12.09.2006
(51) Int. Cl.: H05K 7/20, F24F 7/08

(54) **HEAT EXCHANGE TYPE COOLING DEVICE**

(30) Priority: 21.09.2005 JP 2005273343
(71) Applicant: MATSUSHITA ELECTRIC INDUSTRIAL CO., LTD., Osaka 571-8501 (JP)
(72) Inventor: FUNADA, Naoyuki c/oMatsushita Electric Ind. Co., 2-1-61,Shiromi,Chuo-ku,Osaka-shi Osaka 540-6207 (JP); NAKANO, Yuuji c/oMatsushita Electric Ind. Co., 2-1-61,Shiromi,Chuo-ku, saka-shi Osaka540-6207 (JP); HAGIMOTO, Keisuke c/oMatsushita Electric Ind. Co., 2-1-61,Shiromi,Chuo-ku, Osaka-shi Osaka 540-6207 (JP); YAMAGUCHI, T. c/oMatsushita Electric Ind. Co., 2-1-61,Shiromi,Chuo-ku,Osaka-shi Osaka 540-6207 (JP); MATSUMOTO, M. c/oMatsushita Electric Ind. Co., 2-1-61,Shiromi,Chuo-ku,Osaka-shi Osaka 540-6207 (JP); SAISHU, Kazuki c/oMatsushita Electric Ind. Co., 2-1-61,Shiromi, Chuo-ku, Osaka-shi Osaka 540-6207 (JP); SHIBATA, Hiroshi c/oMatsushita Electric Ind. Co., 2-1-61,Shiromi,Chuo-ku, Osaka-shi Osaka 540-6207 (JP)
(74) Representative: Schwabe - Sandmair - Marx
(86) International application number: PCT/JP2006/318012
(87) International publication number: WO 2007/034705

(57) **Abstract**

A heat exchange type cooling device includes an enclosure, an inside-air passage allowing inside air in the inside of the enclosure to flow through the inside-air passage and returning the flowing inside air to the inside, an outside-air passage allowing outside air at the outside of the enclosure to flow through the outside-air passage and returning the flowing outside air to the outside, an inside-air blower sending the inside air to the inside-air passage, an outside-air blower sending the outside air to the outside-air passage, a heat-exchanging element exchanging heat between the outside air flowing through the outside-air passage and the inside air flowing through the inside-air passage, and a heater for heating the inside air. The outside-air passage is independent from the inside-air passage. The heater is provided upstream of the heat-exchanging element in the inside-air passage. This heat exchange type cooling device can heat and cool the inside of the enclosure while preventing dust and moisture from entering into the inside of the enclosure.

## Description

### TECHNICAL FIELD

The present invention relates to a heat exchange type cooling device for cooling an inside of an enclosure.

### BACKGROUND ART

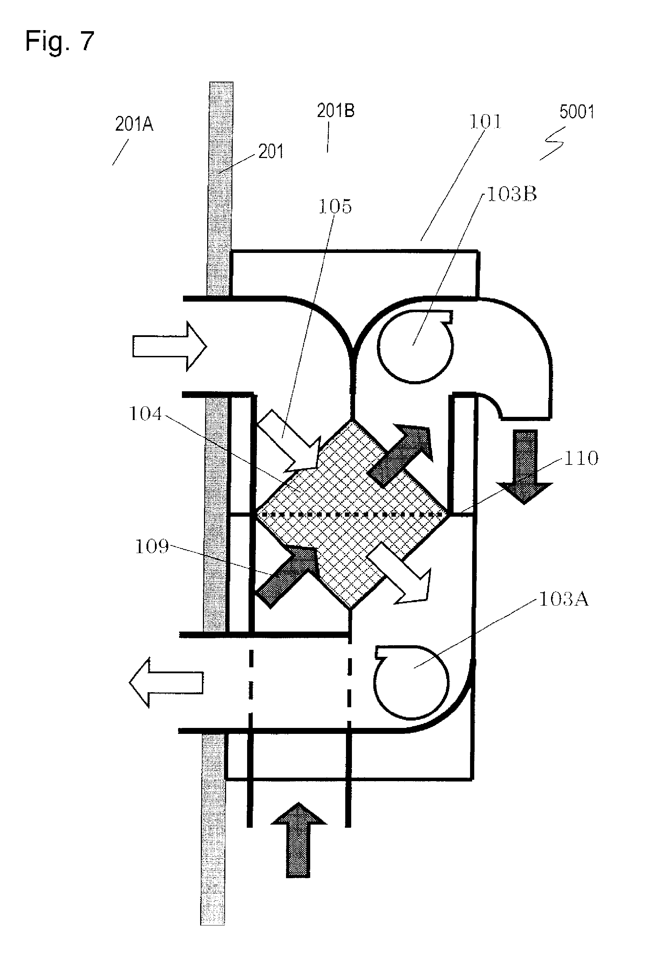

Fig. 7 is a schematic view of a conventional heat exchange type cooling device 5001 disclosed in Japanese Patent Laid-Open Publication No.2001-156478. Cooling device 5001 is placed in case 101. Cooling device 5001 includes inside-air passage 105, outside-air passage 109, partition plate 110, blowers 103A and 103B, and heat-exchanging element 104. Inside-air passage 105 introduces inside air in inside 201A of enclosure 201 accommodating therein a heater, and then returns the air to inside 201A of enclosure 201. Outside-air passage 109 introduces outside air at outside 201B of enclosure 201, and then, exhausts the air to outside 201B of enclosure 201. Partition plate 110 separates inside-air passage 105 and outside-air passage 109 from each other. Blower 103B transfers outside air in outside-air passage 109. Blower 103A transfers inside air in inside-air passage 105. Heat-exchanging element 104 is placed at the intersecting point of inside-air passage 105 and outside-air passage 109, and exchanges sensible heat between the outside air and the inside air. Cooling device 5001 is mounted to enclosure 201, and cools inside 201A of enclosure 201.

Cooling device 5001 cannot warm inside 201A of enclosure 201 when the temperature of outside air at outside 201B of enclosure 201 is low or when inside 201A of enclosure 201 is cool. Enclosure 201 may accommodate, in inside 201A, a device that needs to start at an ambient temperature higher than a predetermined temperature. In this case, the device can not start due to the temperature of inside 201A.

In order to start the device, inside 201A of enclosure 201 needs to be heated temporarily at startup if the temperature of the inside or outside air is lower than the predetermined given temperature for starting the device.

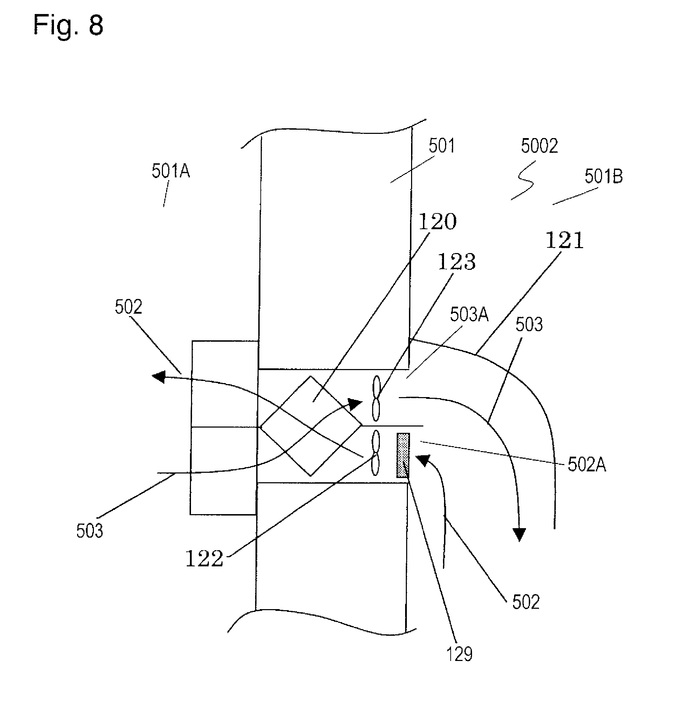

Fig. 8 is a schematic view of a conventional heat-exchanging ventilator 5002 disclosed in Japanese Patent Laid-Open Publication No.2001-156478. Inside air in inside 501A of enclosure 501 is exhausted as exhaust air 503 to outside 501B of enclosure 501 through air outlet 503A. Outside air at outside 501B of enclosure 501 is introduced as supply air 502 to inside 501A of enclosure 501 through air inlet 502A. Heat-exchanging element 120 exchanges heat between exhaust air 503 and supply air 502. Supply fan 122 sends outside air to heat-exchanging element 120. Exhaust fan 123 exhausts inside air to outside 501B through heat-exchanging element 120. Hood 121 is provided at outside 501B for preventing rainwater from entering into air outlet 503A and air inlet 502A. Heater 129 is placed at an upstream of fan 122. Heater 129 heats the outside air introduced through air inlet 502A and sends the heated air to heat-exchanging element 120 so as to prevent heat-exchanging element 120 from having dew condensation in cold climate areas.

Ventilator 5002 introduces outside air directly into inside 501A of enclosure 501, and hence, may cause dust and moisture to enter into inside 501A of enclosure 501 along with supply air 502, thereby adversely affecting the devices accommodated in inside 501 of enclosure 501.

Supply air 502 heated with heater 129 is sent to heat-exchanging element 120. When the inside air is colder than the outside air, supply air 502 (the outside air) warmed with heater 129 is cooled by exhaust air 503 (the inside air) while passing through heat-exchanging element 120, preventing inside 501 of enclosure 501 from being heated efficiently.

### SUMMARY OF THE INVENTION

A heat exchange type cooling device includes an enclosure, an inside-air passage allowing inside air in the inside of the enclosure to flow through the inside-air passage and returning the flowing inside air to the inside, an outside-air passage allowing outside air at the outside of the enclosure to flow through the outside-air passage and returning the flowing outside air to the outside, an inside-air blower sending the inside air to the inside-air passage, an outside-air blower sending the outside air to the outside-air passage, a heat-exchanging element exchanging heat between the outside air flowing through the outside-air passage and the inside air flowing through the inside-air passage, and a heater for heating the inside air. The outside-air passage is independent from the inside-air passage. The heater is provided upstream of the heat-exchanging element in the inside-air passage.

This heat exchange type cooling device can heat and cool the inside of the enclosure while preventing dust and moisture from entering into the inside of the enclosure.

### BRIEF DESCRIPTION OF DRAWINGS

Fig. 1 is a perspective view of an enclosure having a heat exchange type cooling device according to an exemplary embodiment of the present invention.
Fig. 2 is a schematic view of the heat exchange type cooling device according to the embodiment.
Fig. 3 is a perspective view of an essential part of the cooling device according to the embodiment.
Fig. 4 is a schematic view of the cooling device according to the embodiment.
Fig. 5 is a perspective view of a heater of the cooling device according to the embodiment.
Fig. 6A is a perspective view of a heating element of the heater according to the embodiment.
Fig. 6B is a sectional view of the heating element at line 6B-6B shown in Fig. 6A.
Fig. 7 is a schematic view of a conventional heat exchange type cooling device.
Fig. 8 is a schematic view of a conventional heat-exchanging ventilator.

### REFERENCE NUMERALS

- 2: Inside-air Blower
- 3: Heat-Exchanging Element
- 5: Inside-air Passage
- 8: Outside-air Passage
- 9: Outside-air Blower
- 10: Heater
- 21: Heating Element (First Heating Element)
- 21A: Airflow Surface (First Airflow Surface)
- 22: Heating Element (Second Heating Element)
- 22A: Airflow Surface (Second Airflow Surface)
- 24: Airflow Direction
- 26: Heating Element
- 27: Holder (First Holder, Second Holder)
- 33: Thermal Fuse
- 36: Thermolabel
- 601: Enclosure
- 601A: Inside
- 601B: Outside
- 1001: Cooling Device

### DETAILED DESCRIPTION OF THE PREFERRED EMBODIMENT

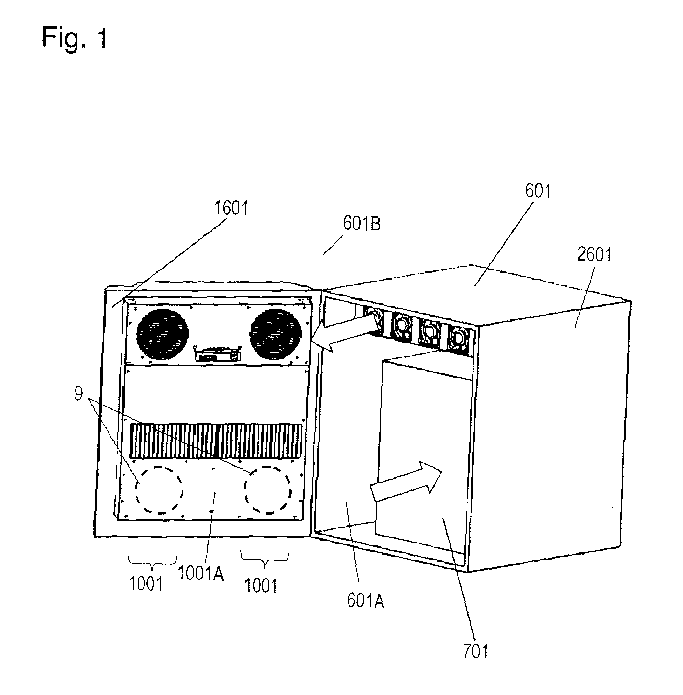

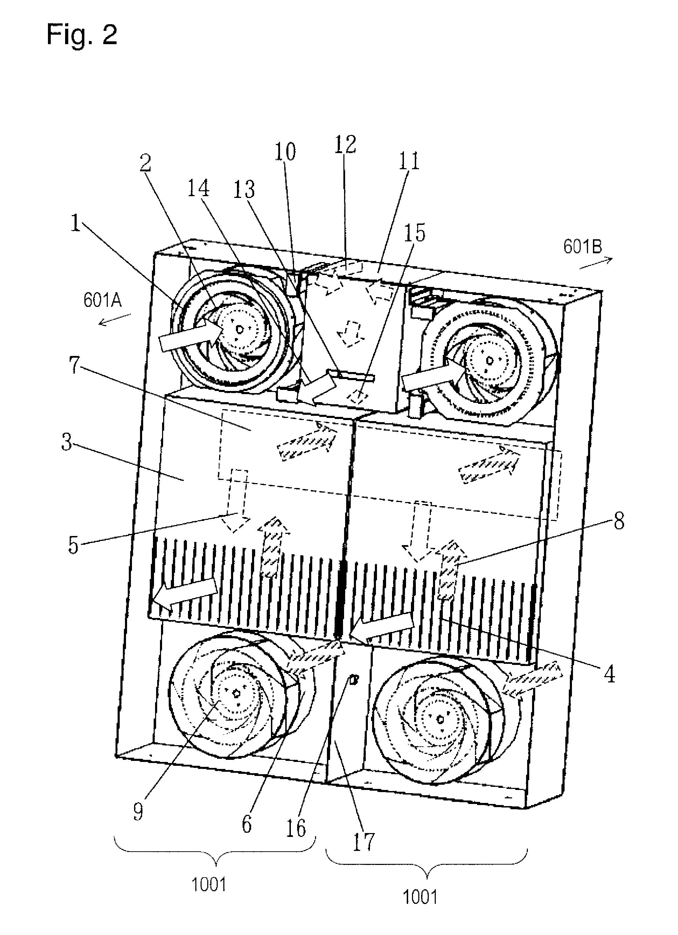

Fig. 1 is a perspective view of enclosure 601 including heat exchange type cooling device 1001 according to an exemplary embodiment of the present invention. Fig. 2 is a schematic view of cooling apparatus 1001. Two cooling devices 1001 are mounted to door 1601 of enclosure 601. In Fig. 1, cooling devices 1001 are mounted in door 1601. Cooling device 1001 may be placed on an inside surface or an outer surface of door 1601, or in the inside, on an outer surface or an inside surface of wall 2601, or in wall 2601. Device 701 is accommodated in inside 601A of enclosure 601.

Enclosure 601 separates between inside 601A and outside 601B. Inside air in inside 601A of enclosure 601 is taken with inside-air blower 2 through inside-air inlet 1, flows through heat-exchanging element 3, and then, returns to inside 601A of enclosure 601 through inside-air outlet 4, thus forming inside-air passage 5. Control box 11 is arranged between inside-air inlet 1 and heat-exchanging element 3 while contacting inside-air passage 5. Heater 10 for heating inside air is provided on a side of control box 11. A part of the inside air taken with inside-air blower 2 through inside-air inlet 1 passes by heater 10, and is sent to heat-exchanging element 3. That is, heater 10 is provided upstream of heat-exchanging element 3 in inside-air passage 5, and inside-air blower 2 is provided upstream of heater 10 in inside-air passage 5. A part of the inside air taken with inside-air blower 2 passes by heater 10, and is introduced into control box 11 through inlet 12 provided in a side of control box 11. The part of the inside air introduced into control box 11 is not sent to heat-exchanging element 3, but returns to inside 601A of enclosure 601 through outlet 13 provided in a front surface of control box 11, thus forming control-box passage 14.

Outside air at outside 601B of enclosure 601 is taken with outside-air blower 9 through outside-air inlet 6 provided in a side opposite to inside-air inlet 1. The outside air taken with outside-air blower 9 passes through heat-exchanging element 3, and is exhausted to the outside again through outside-air outlet 7, thus forming outside-air passage 8.

In Fig. 2, outside-air blower 9 seems to contact inside 601A of enclosure 601. As shown in 1, blower 9 is insulated from inside 601A with insulating plate 1001A, thereby not communicating with inside 601. As shown in Fig. 2, partition plate 17 is provided between respective blowers 9 of two cooling device 1001 so as to prevent respective blowers 9 from communicating with each other.

Thus, inside-air passage 5, control-box passage 14, and outside-air passage 8 are provided independently from one another. Heat-exchanging element 3 is arranged at an intersecting point of outside-air passage 8 and inside-air passage 5 to exchange sensible heat between the outside and the inside air.

Temperature sensor 15 for sensing the temperature of the inside air is provided in control box 11. Temperature sensor 16 for sensing the temperature of the outside air is provided on a side of partition plate 17.

Inside-air blower 2 and outside-air blower 9 may have a speed change function, so that the rotation speeds of blowers 2 and 9 may increase when temperature sensor 15 detects that the temperature of the inside air is higher than a predetermined temperature, thereby responding to the change of the temperature of inside 601A of enclosure 601

Heat exchange type cooling device 1001 according to the embodiment activates outside-air blower 9 to introduce outside air through outside-air inlet 6 when the temperature of the outside air detected by temperature sensor 16 is lower than that of the inside air. Heat-exchanging element 3 exchanges heat between the warm inside air in inside 601A of enclosure 601 and the introduced outside air, thereby warming the outside air and cooling the inside air. The warmed outside air is exhausted to outside 601B of enclosure 601 through outside-air outlet 7. The cooled inside air is sent to inside 601A of enclosure 601 through inside-air outlet 4 to cool device 701 accommodated in inside 601A of enclosure 601.

When both the temperatures of the inside air and the outside air detected by temperature sensors 15 and 16 are low, cooling device 1001 does not activate heat-exchanging element 3, but heats the inside air with inside-air blower 2 and heater 10 and returns the heated air to inside 601A. This operation raises the temperature of inside 601A to a predetermined temperature to allow device 701 to start.

In the heat exchange type cooling device according to the embodiment, outside-air passage 8 and control-box passage 14 are independent from each other, and outside-air passage 8 and inside-air passage 5 are independent and separated from each other. This arrangement prevents the outside air from mixing with the inside air, and hence, prevents moisture and dust contained in the outside air from entering into inside 601A of enclosure 601, hence not affecting device 701.

Heater 10 may employ a heater, a positive temperature coefficient heating element, a sheet heating element, or an indirect resistance heating element.

Heater 10 made of the positive temperature coefficient heating element has a self temperature control function. This heater maintains the temperature of heater 10 safely below a predetermined temperature even if inside-air blower 2 stops due to a failure and only heater 10 operates, thus being safe. The positive temperature coefficient heating element has a temperature rising to a predetermined temperature rapidly after starting energizing, accordingly raising the temperature of the inside air rapidly. This operation can raise the ambient temperature around device 701 safely and rapidly to start device 701.

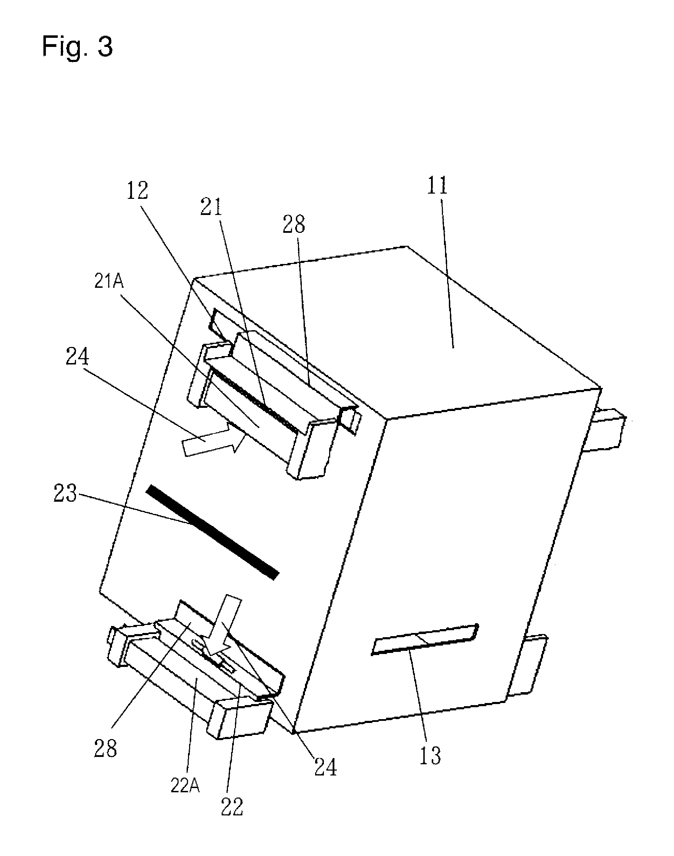

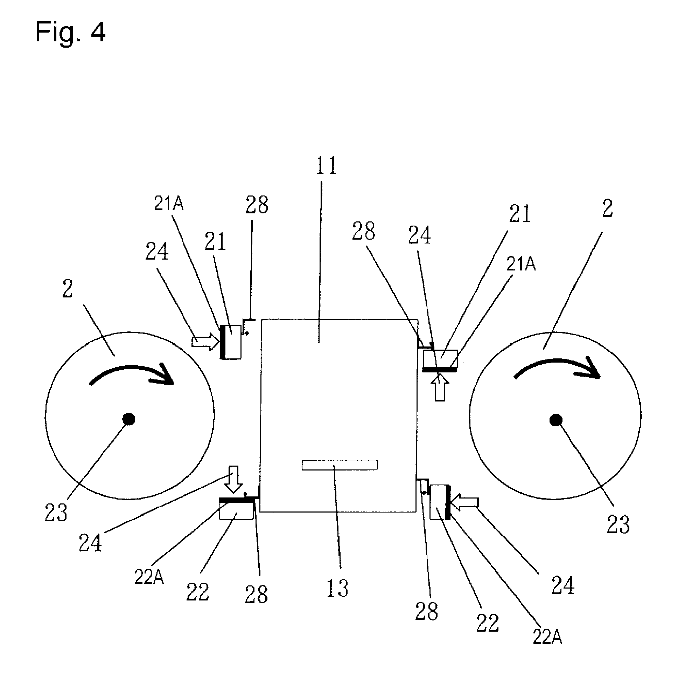

Fig. 3 is a perspective view of heater 10 and control box 11. Fig. 4 is a schematic view of cooling device 1001. As shown in Fig. 4, inside-air blower 2 rotates about rotation axis 23 to send the inside air in airflow direction 24. Heater 10 includes heating elements 21 and 22 having airflow surfaces 21A and 22A, respectively. As air passes along airflow surfaces 21A and 22A faster, heating elements 21 and 22 emit a larger amount of heat, namely, increase their heating performance. Airflow surfaces 21A and 22A are arranged in parallel with rotation axis 23 of inside-air blower 2 and perpendicularly to airflow direction 24. This arrangement maximizes the speed of inside air passing along airflow surfaces 21A and 22A, accordingly allowing heater 10 including heating elements 21 and 22 to heat the inside air efficiently.

Heating elements 21 and 22 may have characteristics, such as heating performance or heating speed, different from each other. For example, if the time in which an inrush current reaches its peak value is different from each other, inrush currents flow into heating elements 21 and 22 at different timing, thereby reducing the total of the inrush currents flowing into heating elements 21 and 22. Thus, the total of the inrush currents flowing into heater 10 at startup can be suppressed while ensuring a high heating performance of heating elements 21 and 22. Specifically, heating element 21 employed a positive temperature coefficient heating element having a Curie temperature of 220°C, a heating performance of 460W at the applying of AC275V, and heating element 22 employed a positive temperature coefficient heating element having a Curie temperature of 240°C, a heating performance of 515W at the applying of AC275V. Under this condition, the total of the inrush currents into heating elements 21 and 22 at startup was 12A at an ambient temperature of 10°C. Meanwhile, the total of the inrush currents flowing into heating elements 21 and 22 at startup was 16 A under the condition that both heating elements 21 and 22 employed positive temperature coefficient heating elements each having a Curie temperature of 220°C, a heating performance of 500W. Thus, even having the same heating performances, the former combination of the heating elements reduces the inrush current by 25% as compared to the latter combination.

Heater 10 may not include one of heating elements 21 and 22.

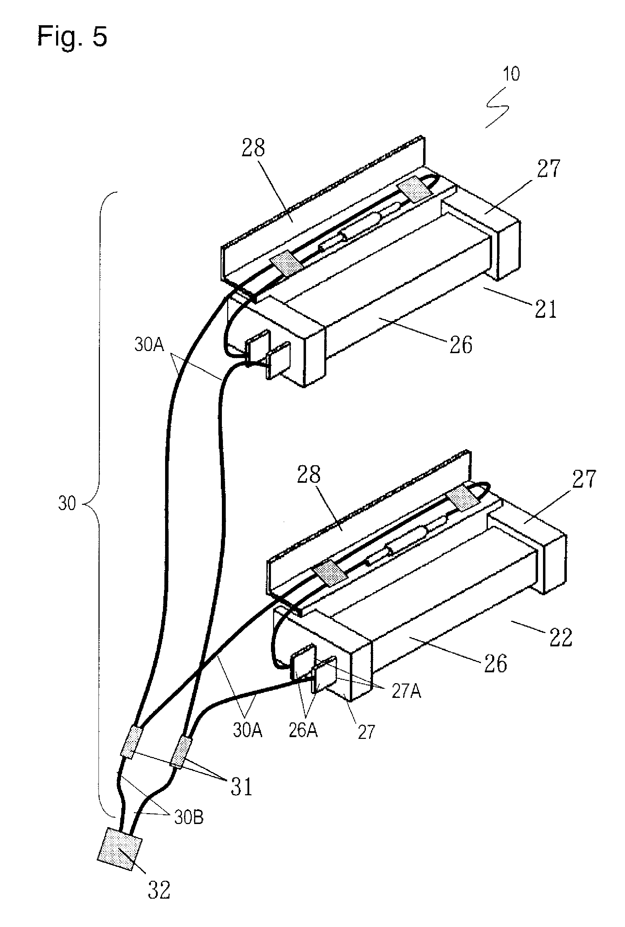

Fig. 5 is a perspective view of heater 10 including heating elements 21 and 22. Each of heating elements 21 and 22 includes heating body 26, two insulative holders 27 holding respective ends of heating body 26, and fixing bracket 28 having holders 27 attached thereto. Holders 27 have the same structure. Holder 27 has hole 27A provided therein. Power terminal 26A for supplying a power to heating body 26 passes through hole 27A. Holders 27 are made of fired-ceramic based material, but may be made of heat-resisting resin molded material.

This structure allows holder 27 and fixing bracket 28 to be commoditized in heating elements 21 and 22, thereby simplifying production control and reducing the inventory of replacement parts.

Heater 10 includes harness 30 connected to power terminals 26A of heating elements 21 and 22, and connector 32 for supplying a power to harness 30. Harness 30 includes wirings 30B connected to connector 32 and wirings 30A branched with connectors 31 from to wirings 30B. Wirings 30B are connected to power terminals 26A to heating elements 21 and 22. In heater 10, heating elements 21 and 22 are connected to connector 32 in parallel with each other.

This arrangement allows heating elements 21 and 22 to be made of parts having the same structure, thus allowing replacement parts to be of one type. This eliminates failure in part replacement, thereby simplifying production control and reducing the inventory of replacement parts.

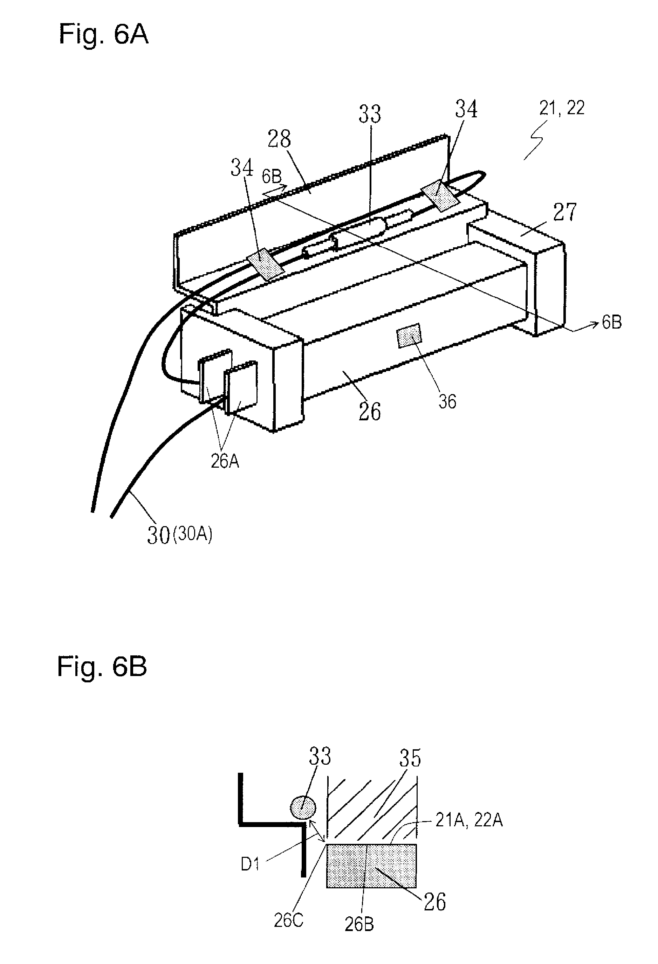

Fig. 6A is a perspective view of heating elements 21 and 22. Fig. 6B is a sectional view of heating elements 21 and 22 at line 6B-6B shown in Fig. 6A. Thermal fuse 33 is inserted in Harness 30 (wiring 30A). Harness 30 (wiring 30A) is attached onto fixing bracket 28 together with thermal fuse 33 with fixing member 34. Thermal fuse 33 is positioned near airflow surfaces 21A and 22A and away from center 26B of heating element 26 along the horizontal direction and from end 26C of heating element 26 by distance D1, about 7 mm. Thermal fuse 33 is attached onto fixing bracket 28 such that thermal fuse 33 does not face airflow surfaces 21A and 22A or enter in passage 35.

This structure allows thermal fuse 33 to promptly cut wirings 30A when the temperature of heating body 26 rises excessively over a predetermined temperature.

Thrmolabel 36 is stuck on heating body 26. Thermolabel 36 has an appearance, such as color, changing upon having a temperature exceeding a predetermined temperature. Heater 10 of cooling device 1001 includes plural heating elements 21 and 22, namely, plural heating elements 26. The change of the appearance, such as color, of thermolabel 36 allows a user to identify heating element 26 which does not function properly without measuring the temperature of element 26.

It may take several hours that the temperature of the surface of heating element 26 reaches a safe temperature after cooling device 1001 is stopped. In this case, the user can determine whether he/she can touch heating element 26 with a hand safely by viewing the appearance of thermolabel 36.

In heat exchange type cooling device 1001 according to the embodiment, the inside air in inside 601A of enclosure 601 can be insulated from the outside air at outside 601B, thereby preventing dust and moisture in the outside air from entering into inside 601A. Consequently, enclosure 601 can accommodate therein, as device 701, a precise device which is sensitive to dust and moisture and which operates at an ambient temperature within a restrict range, and thus, the cooling device can cool and heat the inside of an enclosure, such as a base station for mobile phones, placed outdoors.

### INDUSTRIAL APPLICABILITY

A heat exchange type cooling device according to the present invention can heat and cool the inside of an enclosure while preventing dust and moisture from entering into the inside of the enclosure. This device can accommodate a precise device which is sensitive to dust and moisture and which operates at an ambient temperature within a restrict range, thus being useful for a structure, such as a base station for mobile phones, placed outdoors.

## Claims

1. A heat exchange type cooling device comprising:
an enclosure partitioning between an inside and an outside;
an inside-air passage allowing inside air in the inside of the enclosure to flow through the inside-air passage and returning the flowing inside air to the inside;
an outside-air passage allowing outside air at the outside of the enclosure to flow through the outside-air passage and returning the flowing outside air to the outside, the outside-air passage being independent from the inside-air passage;
an inside-air blower sending the inside air to the inside-air passage;
an outside-air blower sending the outside air to the outside-air passage;
a heat-exchanging element exchanging heat between the outside air flowing through the outside-air passage and the inside air flowing through the inside-air passage; and
a heater for heating the inside air, the heater being provided upstream of the heat-exchanging element in the inside-air passage.

2. The heat exchange type cooling device of claim 1, wherein
the inside-air blower sends the inside air in an airflow direction; and
the heater has an airflow surface arranged perpendicularly to the airflow direction.

3. The heat exchange type cooling device of claim 1, wherein the heater includes a first heating element and a second heating element having characteristics different from each other.

4. The heat exchange type cooling device of claim 3, wherein
the inside-air blower sends the inside air in an airflow direction; and
the first heating element and the second heating element have airflow surfaces arranged perpendicularly to the airflow direction.

5. The heat exchange type cooling device of claim 3, wherein the first heating element includes
a first heating body, and
a first holder holding the first heating body, and the second heating element includes
a second heating body, and
a second holder holding the second heating element.

6. The heat exchange type cooling device of claim 5, wherein the second holder has a structure identical to a structure of the first holder.

7. The heat exchange type cooling device of claim 5, wherein the second heating element has a structure identical to a structure of the first heating element.

8. The heat exchange type cooling device of claim 1, wherein the heater includes
a heating body, and
a thermal fuse operating according to a temperature of the heating body.

9. The heat exchange type cooling device of claim 8, wherein
the heating body has an airflow surface, and
the thermal fuse is positioned near the airflow surface.

10. The heat exchange type cooling device of claim 1, further comprising a thermolabel having an appearance changing according to a temperature of the heater.
